(19) Europäisches Patentamt
European Patent Office
Office européen des brevets

(11) **EP 3 418 266 A1**

(12) **EUROPÄISCHE PATENTANMELDUNG**

(43) Veröffentlichungstag:
26.12.2018 Patentblatt 2018/52

(51) Int Cl.:
*C04B 37/02* (2006.01)　　*H01L 21/02* (2006.01)
*H01L 21/48* (2006.01)　　*H05K 3/00* (2006.01)
*B23K 26/364* (2014.01)

(21) Anmeldenummer: 17177320.3

(22) Anmeldetag: **22.06.2017**

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**
Benannte Erstreckungsstaaten:
**BA ME**
Benannte Validierungsstaaten:
**MA MD**

(71) Anmelder: **Heraeus Deutschland GmbH & Co. KG 63450 Hanau (DE)**

(72) Erfinder:
• **Rogg, Alexander**
**92724 Trabitz (DE)**
• **Lisca, Bogdan**
**30781 Samnihaiu (RO)**

(74) Vertreter: **Gille Hrabal**
**Brucknerstrasse 20**
**40593 Düsseldorf (DE)**

(54) **KERAMIK-METALL-SUBSTRAT MIT GERINGER AMORPHER PHASE**

(57) Beschrieben wird ein Keramik-Metall-Substrat, umfassend ein Keramiksubstrat und auf mindestens einer Seite der Keramiksubstrats eine Metallisierung, dadurch gekennzeichnet, dass das Keramik-Metall-Substrat mindestens eine Ritzlinie und/oder Schneidkante aufweist, wobei sich amorphe Phasen parallel zu der Ritzlinie und/oder der Schneidkante in einer Breite von höchstens 100 μm erstrecken.

Figur 1:

**Beschreibung**

Die vorliegende Erfindung betrifft ein Keramik-Metall-Substrat, in dem das Keramiksubstrat einen geringen Anteil an amorpher Phase aufweist. Weiterer Gegenstand der vorliegenden Erfindung ist die Verwendung entsprechender Keramik-Metall-Substrate.

Direct Copper Bonding Substrate (DCB, auch DBC genannt) sind die am häufigsten verwendeten Schaltungsträger für Leistungselektronik-Anwendungen. Die DCB-Technologie ist eine Fügetechnologie, durch welche bei hohen Temperaturen eine eutektische Verbindung zwischen Kupfer (in der Regel als Kupferfolie) und einer Keramik erzeugt wird. Die DCB-Substrate eignen sich für Anwendungen mit hohen Leistungen, die eine gute Wärmeentkoppelung erfordern.

DCBs bestehen aus einem Keramik-Substrat wie $Al_2O_3$ (oder anderen Keramikmaterialien wie z. B. ZTA, AlN), das als Isolierungsschicht dient, und Kupferverbindungen, um die elektrische Leitfähigkeit zu gewährleisten. Das DCB-Substrat stellt das Rückgrat der Leistungselektronik-Module dar und ist - beispielsweise im Vergleich zu einer gedruckten Leiterplatte (PCB = Printed Circuit Board) - außerordentlich leistungsfähig. Zum einen trägt es die Halbleiterchips und dient zur Wärmeableitung. Zum anderen gewährleistet es die Isolierung hin zum Kühlkörper und zum Umrichtergehäuse.

Für eine optimale Zuverlässigkeit und Performance muss das Modul gute Eigenschaften in Bezug auf Wärmeverteilung und Temperatur- sowie Lastwechselbeständigkeit aufweisen.

Keramik-Metall-Substrate, welche beispielsweise nach dem DCB-Verfahren erhalten werden, werden üblicherweise im sogenannten Mehrfachnutzen produziert. Bei diesem Mehrfachnutzen weisen die Keramik-Substrate zumindest an einer Oberflächenseite, vorzugsweise aber an beiden Oberflächenseiten der Keramikschicht, Einzelmetallisierungen auf, zwischen denen Sollbruchlinien in der Keramikschicht verlaufen, sodass durch Brechen entlang dieser Sollbruchlinien das großflächige Keramik-Metall-Substrat in Einzelsubstrate getrennt werden kann, die dann jeweils die Leiterplatte eines Schaltkreises oder Moduls bilden können. Entsprechende Sollbruchlinien werden auch als Ritzlinien bezeichnet und können durch eine Laserbehandlung erzeugt werden.

Auch kann mittels der Laserbehandlung ein Durchtrennen des Keramik-Metall-Substrats erfolgen. Beide Verfahrensschritte der Laserablation werden in der vorliegenden Anmeldung als Ritzen (Einbringen einer Ritzlinie in das Keramik-Metall-Substrat) oder als Schneiden (vollständiges Durchtrennen des Keramik-Metall-Substrats) bezeichnet.

In beiden Fällen der Laserablation wird durch den Laserstrahl und das damit verbundene Einbringen von thermischer Energie das Keramiksubstrat aufgeschmolzen. Hierbei bildet sich entlang der Ritzlinien bzw. entlang der durch das Schneiden erzeugten Kante (im Folgenden als Schneidkante bezeichnet) in dem Keramikmaterial eine amorphe Phase.

Dass diese amorphe Phasen für die weitere Verarbeitung nachteilig sind, wurde bereits in der WO 2005/008849 A2 erkannt, in welcher ein Verfahren zur Erzeugung einer Sollbruchlinie in einem Keramiksubstrat beschrieben wird. In diesem Verfahren wird der Vorgang der Laserablation so durchgeführt, dass die Seitenwände der erzeugten Laserritzlinien kaum aufgeschmolzen werden. Hierdurch wird die Bildung von amorphen Phasen entlang der Laserritzlinien unterdrückt. Allerdings sind die in der WO 2005/008849 A2 angewendeten Betriebsgeschwindigkeiten (Vortriebsgeschwindigkeiten) des Lasers sehr gering (in den Ausführungsbeispielen werden Betriebsgeschwindigkeiten (Vortriebsgeschwindigkeiten) in einem Bereich von 25 mm/s bis 100 mm/s, d.h. von 0,025 bis 0,01 m/s) angewendet, was für eine wirtschaftliche Fertigung von Keramik-Metall-Substraten ungeeignet ist.

US 9,165,832 B offenbart ein Verfahren zur Erzeugung einer Ritzlinie in einem Halbleiterwafer, wobei darauf hingewiesen wird, dass durch die Laserablation Defekte in dem Wafer erzeugt werden, die sich auf einer Breite von 2 $\mu$m erstrecken. Die in der US 9,165,832 B beschriebene Verfahrensweise ist nicht unmittelbar und eindeutig auf die Anwendung an Keramik-Metall-Substrate übertragbar.

Im Rahmen der vorliegenden Erfindung wurde nun festgestellt, dass die Ausbildung von diesen durch Laserablation erzeugten amorphen Phasen in einem gewissen Umfang für die weitere Bearbeitung des Keramik-Metall-Substrats nachteilig sind. So kann es beispielsweise bei der Erzeugung einer Ritzlinie und dem anschließenden Zertrennen des Keramik-Metall-Substrats, beispielsweise in der Form einer Mehrfachkarte, zu Wildbrüchen kommen. Diese Wildbrüche lassen sich auf Spannungen in der Keramik zurückführen, da es während der Laserablation zu einem Aufschmelzen des keramischen Materials kommt und sich das keramische Material in ein amorphes Material umwandelt. Da das kristalline keramische Material eine andere Dichte und einen anderen Wärmeausdehnungskoeffizient aufweist und während des Prozesses auch unterschiedlichen Temperaturen als das amorphe Material ausgesetzt ist, ist die Laserablation im direkt umgebenen Bereich mit einer Volumenveränderung verbunden. Dieser Umstand führt zu einem Stressaufbau in dem Keramik-Metall-Substrat.

Darüber hinaus kann es bei der Laserablation durch Aufschmelzen des Keramikmaterials trotz Verwendung eines Prozessgases, welches die aufgeschmolzenen Keramikpartikel auf die Keramik herunterdrückt, zu Spritzern der amorphen Phase kommen, die elektronische Bauteile überdecken oder zu anderweitigen Verschmutzungen führen.

Auch beim Schneiden von Keramik-Metall-Substraten können amorphe Phasen am Rand des Keramiksubstrats sich störend auswirken. So können die amorphen Phasen beispielsweise beim Einbringen von randseitigen Löchern, beispielsweise um das Keramik-Metall-Substrat zu verschrauben, zu Problemen führen.

Ein weiteres Problem ist das unkontrollierte Abplatzen der amorphen Phasen, das zu Verunreinigung der Produktionsumgebung führt sowie oberflächliche Kratzer in der Metallisierung des Keramik-Metall-Substrates verursachen kann.

Daher besteht Bedarf nach Keramik-Metall-Substraten, welche einerseits die vorgenannten Nachteile vermeiden und andererseits noch wirtschaftlich hergestellt werden können. Die vorliegende Erfindung stellt sich somit die Aufgabe, Keramik-Metall-Substrate bereitzustellen, die nach dem Einfügen einer Ritzlinie und bei Vereinzelung an der Ritzlinie weder zu einem unkontrollierten Wildbruch noch zu einer Ausbildung von Spritzern der amorphen Phase führen. Des Weiteren sollen die Keramik-Metall-Substrate beim Schneiden einfach weiterverarbeitet werden können. Hierfür ist es notwendig, dass die Keramik-Metall-Substrate einen gewissen Grenzwert nicht übersteigenden Anteil an amorphen Phasen aufweisen. Gleichzeitig muss die Bildung dieser amorphen Phasen für ein wirtschaftliches Herstellverfahren nicht vollständig unterbunden werden. Ferner kann ein geringer kontrollierter Anteil an amorphen Phasen in dem Keramiksubstrat, beispielsweise bei der Vereinzelung, von Vorteil sein. Die vorliegende Erfindung stellt sich daher die Aufgabe, den Anteil an amorphen Phasen, der im Bereich einer Laserablation zulässig sein kann, zu optimieren.

Gelöst werden diese Aufgaben durch ein Keramik-Metall-Substrat, umfassend ein Keramiksubstrat und auf mindestens einer Seite des Keramiksubstrats eine aufgebrachte Metallisierung.

Das erfindungsgemäße Keramik-Metall-Substrat ist dadurch gekennzeichnet, dass das Keramiksubstrat mindestens eine Ritzlinie und/oder Schneidkante aufweist, wobei sich amorphe Phasen parallel zu der Ritzlinie und/oder der Schneidkante in einem Bereich einer Breite a von höchstens 100 $\mu$m erstrecken.

Erfindungsgemäß ist also ein Keramik-Metall-Substrat vorgesehen, bei welchem die Bildung von einer amorphen Phase durch die Laserablation, die entweder zu einer Ritzlinie oder aber zu einem Durchschneiden des Keramik-Metall-Substrats führt, auf einen bestimmten Bereich entlang der Laserritzlinie oder aber der Schneidkante des Keramik-Metall-Substrats im Wesentlichen beschränkt ist. Damit wird gleichzeitig die Bildung von amorphen Phasen insgesamt eingeschränkt und die vorstehend genannten Nachteile werden vermieden.

Die Erzeugung der Ritzlinie oder der Schneidkante erfolgt, wie schon ausgeführt, vorzugsweise durch Materialabtrag mittels Laserbehandlung (Laserablation).

Das erfindungsgemäße Keramik-Metall-Substrat ist vorzugsweise ein DCB-Substrat, ein AMB-Substrat, ein DAB- oder ein IMS-Substrat. In einer weiteren Bezug Ausgestaltung der vorliegenden Erfindung kann es sich bei dem Keramik-Metall-Substrat und ein Keramik-Metall-Substrat gemäß der prioritätsälteren, nicht vorveröffentlichten Internationalen Patentanmeldung PCT/EP2016/082161 handeln.

Im Rahmen der vorliegenden Erfindung wird unter dem Merkmal "im Wesentlichen parallel zu der Ritzlinie und/oder der Schneidkante" verstanden, wenn einzelne Abstände amorpher Phasen von dem mittleren maximalen Abstand der amorphen Phase von der Laserritzlinie bzw. Schneidkante um vorzugsweise maximal 30 %, weiter bevorzugt maximal 20 %, weiter bevorzugt maximal 15 %, abweichen.

Durch die Laserablation wird beispielsweise eine Ritzlinie dergestalt in das Keramik-Metall-Substrat eingebracht, dass ein Graben gebildet wird. Dieser Graben weist eine Breite auf, die sich ausgehend von der äußeren Seite des Keramik-Metall-Substrats, das heißt von der Metallisierung, in Richtung des Keramiksubstrats verjüngt. Diese Laserritzlinie umfasst zwei Wände, die konvergierend zur Mitte des Keramiksubstrats verlaufen. Die hierbei gebildete Form des Grabens kann beispielsweise triangular mit einer Öffnung und einer Spitze sein. Alternativ ist auch eine triangular-ähnliche Form möglich des Grabens, wobei zusätzlich die Spitze abgerundet sein kann. Die Tiefe des Grabens ist vorzugsweise so ausgebildet, dass die gebildete Ausnehmung nicht die gesamte Schichtdicke des Keramiksubstrats penetriert.

Durch die Laserablation kann darüber hinaus im Rahmen der vorliegenden Erfindung auch eine Schneidkante des Keramik-Metall-Substrats gebildet werden. In diesem Fall kann die Schneidkante einen abgeschrägten oder im Wesentlichen senkrechten Verlauf aufweisen.

Die vorliegende Erfindung wird anhand der nachfolgenden Figuren, die bevorzugte Ausgestaltungen verdeutlichen, näher beschrieben.

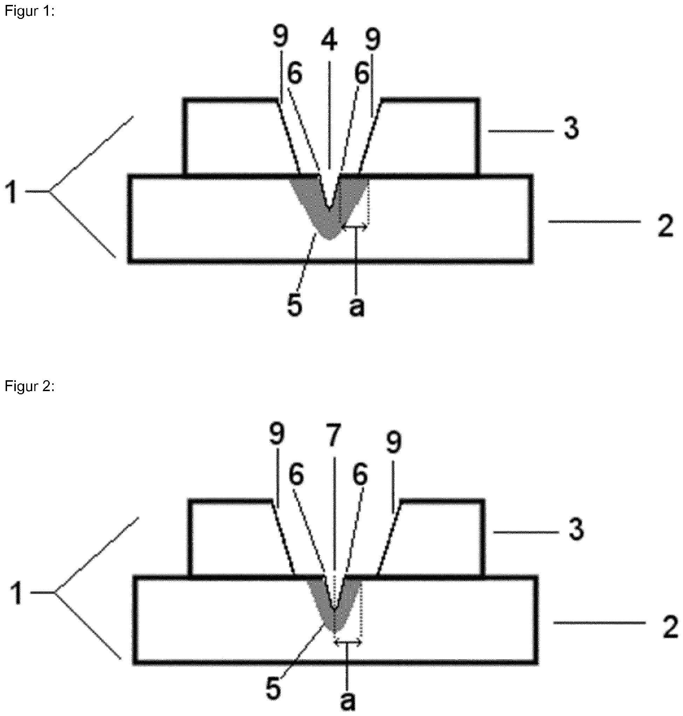

Figur 1     zeigt ein Keramik-Metall-Substrat 1, welches eine Ritzlinie 4 gemäß erster Ausführungsform der vorliegenden Erfindung aufweist.

Die Figur 1 zeigt ein Keramik-Metall-Substrat 1, welches eine Ritzlinie 4 aufweist. Das Keramik-Metall-Substrat 1 umfasst ein Keramiksubstrat 2 mit einer zumindest auf einer Seite des Keramiksubstrats 2 aufgebrachten Metallisierung 3. In die Metallisierung 3 ist eine Ausnehmung 10 eingebracht, die üblicherweise durch einen Ätzvorgang gebildet wird. Die Ausnehmung 10 reicht dabei bis zum Keramiksubstrat 2. In das Keramiksubstrat 2 ist im Bereich der Ausnehmung 10 eine Ritzlinie 4 vorgesehen. Die Ritzlinie 4 unterteilt das Keramik-Metall-Substrat 1 in unterschiedliche Bereiche. Es ist vorgesehen, dass das Keramik-Metall-Substrat 1 entlang der Ritzlinie 4 gebrochen wird. Im Wesentlich parallel zu dieser Ritzlinie 4, die im Rahmen der vorliegenden Erfindung im Allgemeinen durch eine Laserablation erzeugt wird, erstreckt sich auf und/oder innerhalb des Keramiksubstrats 2 eine amorphe Phase 5. Die amorphe Phase 5 erstreckt sich, ausgehend von der Ritzlinie 4 und parallel zur Ritzlinie 4 verlaufend, in einem Bereich einer Breite a, berechnet von der Kante 6 der Ritzlinie 4, von im Allgemeinen höchstens 50 $\mu$m, vorzugsweise höchstens 45 $\mu$m, weiter bevorzugt höchstens 40 $\mu$m, weiter bevorzugt höchstens 35 $\mu$m, noch weiter bevorzugt höchstens 30 $\mu$m. Eine amorphe Phase, die weiter von der Kante 6 der Ritzlinie 4 als definiert beabstandet ist, weist das erfindungsgemäße Keramik-Metall-Substrat 1 vorzugsweise nicht auf. Die minimale Breite a der amorphen Phase 5 beträgt, berechnet von der Kante 6 der Ritzlinie 4, im Allgemeinen mindestens 0,50 $\mu$m, vorzugsweise mindestens 1,00 $\mu$m, weiter bevorzugt mindestens 1,50 $\mu$m, weiter bevorzugt mindestens 2,00 $\mu$m, weiter bevorzugt mindestens 2,50 $\mu$m, weiter bevorzugt mindestens 3 $\mu$m, weiter bevorzugt mindestens 5 $\mu$m, weiter bevorzugt mindestens 8 $\mu$m, weiter bevorzugt mindestens 10 $\mu$m, noch weiter bevorzugt mindestens 12 $\mu$m. Die amorphe Phase 5 kann sich, je nach Verfahrensführung der Laserablation, nur in eine Richtung als auch in beide Richtung senkrecht zur Ritzlinie erstrecken. Der Bereich der Breite a bezieht sich aber auf die Ausdehnung der amorphen Phase nur in eine Richtung. Die Kante 6 der Ritzlinie 4 steht für den Punkt auf der Oberfläche des Keramiksubstrats 2 , an welchem das Keramiksubstrat in die Ritzlinie 4 übergeht.

Figur 2     zeigt ein Keramik-Metall-Substrat 1, welches eine Ritzlinie 4 gemäß zweiter Ausführungsform der vorliegenden Erfindung aufweist.

Die Figur 2 zeigt ein Keramik-Metall-Substrat 1, welches eine Ritzlinie 4 aufweist. Das Keramik-Metall-Substrat 1 umfasst ein Keramiksubstrat 2 mit zumindest auf einer Seite des Keramiksubstrats 2 aufgebrachten Metallisierung 3. In die Metallisierung 3 ist eine Ausnehmung 10 eingebracht, die üblicherweise durch einen Ätzvorgang gebildet wird. Die Ausnehmung 10 reicht dabei bis zum Keramiksubstrat 2. In das Keramiksubstrat 2 ist im Bereich der Ausnehmung 10 eine Ritzlinie 4 vorgesehen. Die Ritzlinie 4 unterteilt das Keramik-Metall-Substrat 1 in unterschiedliche Bereiche. Es ist vorgesehen, dass das Keramik-Metall-Substrat 1 entlang der Ritzlinie 4 gebrochen wird. Im Wesentlich parallel zu dieser Ritzlinie 4, die im Rahmen der vorliegenden Erfindung im Allgemeinen durch eine Laserablation erzeugt wird, erstreckt sich auf und/oder innerhalb des Keramiksubstrats 2 eine amorphe Phase 5. Die amorphe Phase 5 erstreckt sich, ausgehend von der Ritzlinie 4 und parallel zur Ritzlinie 4 verlaufend, in einem Bereich einer Breite a, berechnet von der Mittellinie 7 der Ritzlinie 4, von im Allgemeinen höchstens 100 $\mu$m, vorzugweise höchstens 80 $\mu$m, weiter bevorzugt höchstens 60 $\mu$m, weiter bevorzugt höchstens 40 $\mu$m, noch weiter bevorzugt höchstens 20 $\mu$m. Die Mittellinie 7 der Ritzlinie 4 ist definiert als die Linie auf der Oberfläche des Keramiksubstrats 2, die von beiden Kanten 6 der Ritzlinie 4 auf der Oberfläche des Keramiksubstrat 2 gleich weit entfernt ist. Eine amorphe Phase, die weiter von der Mittellinie 7 der Ritzlinie 4 als definiert beabstandet ist, weist das erfindungsgemäße Keramik-Metall-Substrat 1 vorzugsweise nicht auf. Die minimale Breite a der amorphen Phase 5 beträgt, berechnet von der Mittellinie 7 der Ritzlinie 4, im Allgemeinen mindestens 0,50 $\mu$m, vorzugsweise mindestens 1,00 $\mu$m, weiter bevorzugt mindestens 1,50 $\mu$m, weiter bevorzugt mindestens 2,00 $\mu$m, weiter bevorzugt mindestens 2,50 $\mu$m, weiter bevorzugt mindestens 3 $\mu$m, weiter bevorzugt mindestens 5 $\mu$m, weiter bevorzugt mindestens 8 $\mu$m, weiter bevorzugt mindestens 10 $\mu$m, noch weiter bevorzugt mindestens 12 $\mu$m. Die amorphe Phase 5 kann sich, je nach Verfahrensführung der Laserablation, nur in eine Richtung als auch in beide Richtung senkrecht zur Ritzlinie erstrecken. Der Bereich der Breite a bezieht sich aber auf die Ausdehnung der amorphen Phase nur in eine Richtung.

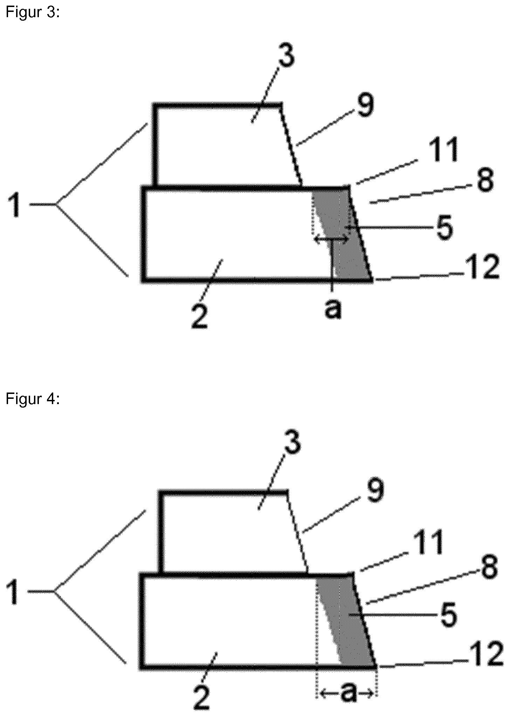

Figur 3     zeigt ein Keramik-Metall-Substrat 1, welches eine Schneidkante 8 in dem Keramiksubstrat 2 gemäß dritter Ausführungsform der vorliegenden Erfindung aufweist.

Die Figur 3 zeigt ein Keramik-Metall-Substrat 1, welches eine Schneidkante 8 in dem Keramiksubstrat 2 aufweist. Das Keramik-Metall-Substrat 1 umfasst ein Keramiksubstrat 2 mit zumindest einer auf einer Seite des Keramiksubstrats 2 aufgebrachten Metallisierung 3. Das Keramiksubstrat 2 weist randseitig eine Schneidkante 8 auf, von welcher die Metallisierung 3 zurückgesetzt ist. Die Metallisierung 3 ist randseitig von der Schneidkante 8 üblicherweise durch einen Ätzvorgang zurückgesetzt; das heißt, dass die oberhalb der Schneidkante 8 angeordnete Metallisierung 3 durch einen Ätzvorgang so entfernt ist, dass die Metallisierung 3 von der Schneidkante 8 zurückgesetzt ist. Die Schneidkante 8 des Keramiksubstrat 2 weist eine innenliegende Kante 11 und eine außenliegende Kante 12 auf. Die Schneidkante 8 des Keramiksubstrats 2 wird im Rahmen der vorliegenden Erfindung im Allgemeinen durch Laserablation gebildet, wobei ein größeres Keramik-Metall-Substrat (Mehrfachnutzen) durch die Laserbehandlung (Laserablation) getrennt wird. Die amorphe Phase 5 erstreckt sich, ausgehend von der innenliegenden Kante 11, die von der Schneidkante 8 in dem Keramiksubstrat 2 gebildet wird und parallel zur Schneidkante 8 verläuft, in einem Bereich einer Breite a, berechnet von dieser innenliegenden Kante 11 der Schneidkante 8, von im Allgemeinen höchstens 50 $\mu$m, vorzugsweise höchstens 45 $\mu$m, weiter bevorzugt höchstens 40 $\mu$m, weiter bevorzugt höchstens 35 $\mu$m, noch weiter bevorzugt höchstens 30 $\mu$m. Eine amorphe Phase, die weiter von der Kante der Metallisierung 6 als definiert beabstandet ist, weist das erfindungsgemäße Keramik-Metall-Substrat 1 vorzugsweise nicht auf. Die minimale Breite a der amorphen Phase 5 beträgt, berechnet von der dieser innenliegenden Kante der Schneidkante 8, im Allgemeinen mindestens 0,50 $\mu$m, vorzugsweise mindestens 1,00 $\mu$m, weiter bevorzugt mindestens 1,50 $\mu$m, weiter bevorzugt mindestens 2,00

μm, weiter bevorzugt mindestens 2,50 μm, weiter bevorzugt mindestens 3 μm, weiter bevorzugt mindestens 5 μm, weiter bevorzugt mindestens 8 μm, weiter bevorzugt mindestens 10 μm, noch weiter bevorzugt mindestens 12 μm.

Figur 4　　　zeigt ein Keramik-Metall-Substrat 1, welches eine Schneidkante 8 in dem Keramiksubstrat 2 gemäß vierter Ausführungsform der vorliegenden Erfindung aufweist.

Die Figur 4 zeigt ein Keramik-Metall-Substrat 1, welches eine Schneidkante 8 aufweist. Das Keramik-Metall-Substrat 1 umfasst ein Keramiksubstrat 2 mit zumindest einer auf einer Seite des Keramiksubstrats 2 aufgebrachten Metallisierung 3. Das Keramiksubstrat 2 weist eine Schneidkante 8 auf, von welcher die Metallisierung 3 zurückgesetzt ist. Die Metallisierung 3 ist randseitig von der Schneidkante 8 üblicherweise durch einen Ätzvorgang zurückgesetzt; das heißt, dass die oberhalb der Schneidkante 8 angeordnete Metallisierung 3 durch einen Ätzvorgang so entfernt ist, dass die Metallisierung 3 von der Schneidkante 8 zurückgesetzt ist. Die Schneidkante 8 des Keramiksubstrats 2 weist eine innenliegende Kante 11 und eine außenliegende Kante 12 auf. Die Schneidkante 8 des Keramiksubstrats 2 wird im Rahmen der vorliegenden Erfindung im Allgemeinen durch Laserablation gebildet, wobei ein größeres Keramik-Metall-Substrat (Mehrfachnutzen) durch die Laserbehandlung getrennt wird. Die amorphe Phase 5 erstreckt sich, ausgehend von der außenliegenden Kante 12, die von der Schneidkante 8 in dem Keramiksubstrat 2 gebildet wird und parallel zur Kante des Keramiksubstrats 2 verläuft, in einem Bereich einer Breite a, berechnet von dieser außenliegenden Kante 12 der Schneidkante 8, von im Allgemeinen höchstens 100 μm, vorzugweise höchstens 80 μm, weiter bevorzugt höchstens 60 μm, weiter bevorzugt höchstens 40 μm, noch weiter bevorzugt höchstens 20 μm. Eine amorphe Phase, die weiter von der außenliegenden Kante 12 des Keramiksubstrats 2 als definiert beabstandet ist, weist das erfindungsgemäße Keramik-Metall-Substrat 1 vorzugsweise nicht auf. Die minimale Breite a der amorphen Phase 5 beträgt, berechnet von dieser außenliegenden Kante 12 der Schneidkante 8, im Allgemeinen mindestens 0,50 μm, vorzugsweise mindestens 1,00 μm, weiter bevorzugt mindestens 1,50 μm, weiter bevorzugt mindestens 2,00 μm, weiter bevorzugt mindestens 2,50 μm, weiter bevorzugt mindestens 3 μm, weiter bevorzugt mindestens 5 μm, weiter bevorzugt mindestens 8 μm, weiter bevorzugt mindestens 10 μm, noch weiter bevorzugt mindestens 12 μm.

In den in den Figuren 3 und 4 dargestellten Ausführungsformen wird zwischen der innenliegenden Kante 11 und der außenliegenden Kante 12 unterschieden. Diese beiden Kanten 11 und 12 sind nur dann von Bedeutung, wenn die Schneidkante 8 abgeschrägt ist. Sollte die Schneidkante 8 senkrecht zur Oberfläche des Keramiksubstrats 2 verlaufen, ist der Bereich der Breite a für die innenliegenden Kante 11 (Figur 3) und der außenliegenden Kante 12 (Figur 4) identisch und orientiert sich an den in der Figur 4 gegebenen numerischen Werten.

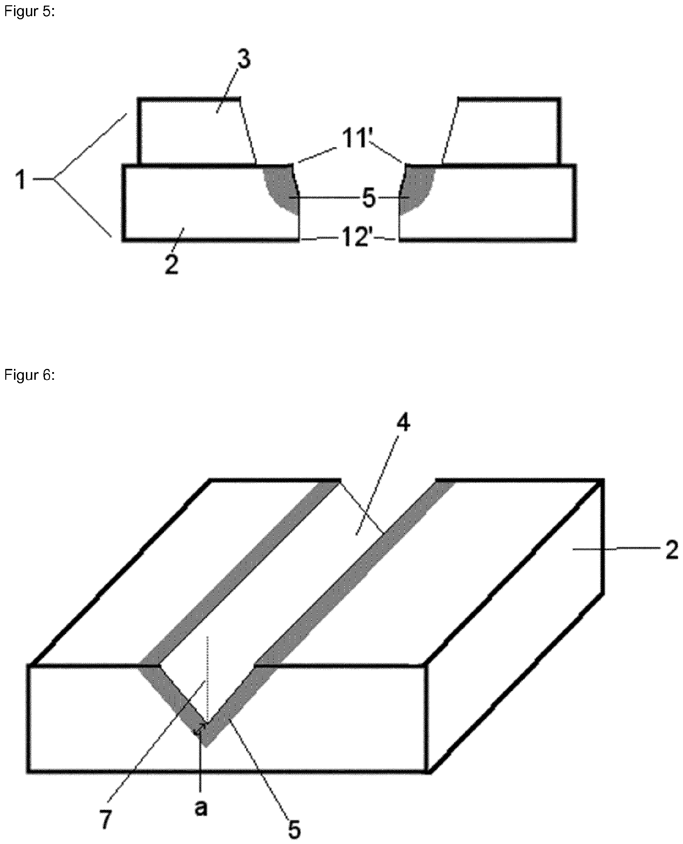

Figur 5　　　zeigt gemäß den Ausführungsformen der Figuren 1 und 2 vereinzelte Keramik-Metall-Substrate 1.

Wenn das in den Ausführungsformen der Figuren 1 und 2 beschriebene Keramik-Metall-Substrat 1 in der Ritzlinie 4 vereinzelt wird (z.B. durch Brechen), entstehen zwei einzelne Keramik-Metall-Substrate, bei denen die amorphen Phasen 5 in einer Breite ausgehend von den Kanten 11' und 12' (analog den Ausführungsformen der Figuren 3 und 4; Bezugzeichen 11 und 12) vorliegen. Es gelten die Bereichsangaben der Figuren 3 und 4.

Figur 6　　　zeigt ein Keramik-Metall-Substrat 1, welches eine Ritzlinie 4 gemäß erster oder zweiter Ausführungsform aufweist.

Die Figur 5 verdeutlicht die dreidimensionale Struktur eine Ritzlinie 4 in dem Keramiksubstrat 2, wobei exemplarisch verdeutlicht wird, wie sich die amorphe Phase 5 parallel zur Ritzlinie 4 erstreckt. Eine analoge Anordnung ergibt sich in dem Fall einer Schneidkante (nicht dargestellt).

Die amorphe Phase 5 erstreckt sich parallel zu der Ritzlinie 4. Dabei weist das Keramiksubstrat 2 die amorphe Phase 5 nach der anspruchsgemäßen Definition zumindest für eine Länge, parallel zur Ritzlinie 4, von mindestens 20 μm, vorzugsweise mindestens 30 μm, weiter bevorzugt mindestens 40 μm, weiter bevorzugt mindestens 50 μm, weiter bevorzugt mindestens 100 μm, weiter bevorzugt mindestens 150 μm, , weiter bevorzugt mindestens 200 μm, weiter bevorzugt mindestens 250 μm, weiter bevorzugt mindestens 300 μm, weiter bevorzugt mindestens 400 μm, noch weiter bevorzugt mindestens 500 40 μm, auf.

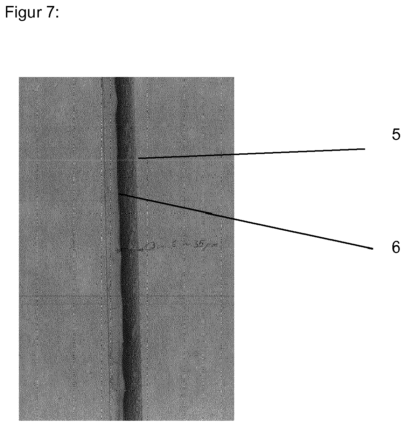

Figur 7　　　zeigt eine REM-Aufnahme einer Ritzlinie 4 mit parallel sich erstreckender amorphen Phase 5.

Kristalline und amorphe Strukturen, d.h. insbesondere die Keramikphase und die amorphe Phase, können anhand von REM-Aufnahmen eindeutig bestimmt werden. Auch die Breite der amorphen Phase lässt sich anhand einer REM-Aufnahme ablesen. Die Figur 6 zeigt eine Ritzlinie 4 sowie eine amorphe Phase 5, die in dieser Ausführungsform nur auf einer Seite der Ritzlinie 4 vorliegt.

In den Ausführungsformen gemäß den Figuren1 bis 4 wird eine Breite a definiert. Diese Breite erstreckt sich nur in eine Richtung ausgehend von der Kante 6 der Ritzlinie 4, der Mittellinie 7 der Ritzlinie 4, der innenliegende Kante 11 der Schneidkante 8 und der außenliegende Kante 12 der Schneidkante 8.

Die Definition der Breite a in der vorliegenden Erfindung ist so zu verstehen, dass sich die amorphen Phasen in dem Bereich dieser Breite a befinden; nicht notwendigerweise ist die Breite a so zu verstehen, dass sich die amorphen Phasen über die gesamte Breite a kontinuierlich erstrecken. Es ist ausreichend, wenn sich amorphe Phasen irgendwo in dem Breitenbereich vorliegen. Auch eine über die Breite a diskontinuierliche amorphe Phase ist von der vorliegenden Erfindung umfasst.

In den zuvor beschriebenen Ausführungsformen erstrecken sich die amorphen Phasen 5 in einem Bereich im Wesentlichen parallel zu den jeweils durch Laserablation erzeugten Ausnehmungen oder Kanten der erfindungsgemäßen Keramik-Metall-Substrate 1.

Im Fall der Erzeugung einer Ritzlinie als Sollbruchlinie, insbesondere einer Laserritzlinie, in dem Keramik-Metall-Substrat kann diese entweder durchgängig oder unterbrochen in dem Keramik-Metall-Substrat erzeugt werden. Damit ein anschließendes Brechen des Keramik-Metall-Substrats einfach möglich ist, ist es bevorzugt, wenn die Tiefe der Laserritzlinie 5 bis 50 %, weiter bevorzugt 8 bis 45 %, noch weiter bevorzugt 10 bis 40 %, der Schichtdicke des Keramiksubstrats beträgt.

Im Fall der Erzeugung einer Ritzlinie als Sollbruchlinie, insbesondere einer Laserritzlinie, in dem Keramik-Metall-Substrat, kann die Tiefe der Ritzlinie mindestens 20 $\mu$m, weiter bevorzugt mindestens 30 $\mu$m, noch weiter bevorzugt mindestens 50 $\mu$m, jeweils bezogen senkrecht auf eine planare Oberfläche des Keramiksubstrats, betragen.

Bei einem Keramiksubstrat mit einer Schichtdicke von 0,63 mm beträgt die Zieltiefe der Laserritzlinie vorzugsweise 40 bis 140 $\mu$m, weiter bevorzugt 50 bis 130 $\mu$m, noch weiter bevorzugt 60 bis 120 $\mu$m.

Das erfindungsgemäße Keramik-Metall-Substrat kann auch Ritzlinien aufweisen, die je nach Bedarf hiervon abweichende Tiefen aufweisen. Beispielsweise kann das erfindungsgemäße Keramik-Metall-Substrat so ausgestaltet sein, dass die Ritztiefe im Anfangsbereich der Ritzlinie höher ist, um eine Initiierung des Bruches zu erleichtern oder um den Bruchverlauf im Übergang zwischen Schneid- und Ritzkonturen zu optimieren. Beispielsweise kann in dem Fall, in welchem die Außenkontur eines Keramik-Metall-Substrats abgerundet werden soll und daher aufgrund des geringen Rundungsradius geschnitten werden muss, sich an den Ecken des Keramik-Metall-Substrats ein Loch ergeben, in dem der Bruchverlauf aus der Ritzlinie gestoppt wird und auf der anderen Seite des Lochs wieder neu initiiert werden muss. In dem Bereich der Neueinleitung des Risses in die Laserritzlinie kann dann vorzugsweise eine höhere Ritztiefe erzeugt werden, um diesen Vorgang der Riss-Neueinleitung zu erleichtern.

Die erfindungsgemäße Ritzlinie weist eine Breite von vorzugsweise 15 bis 75 $\mu$m, weiter vorzugsweise 20 bis 70 $\mu$m, weiter bevorzugt 25 bis 65 $\mu$m, noch weiter bevorzugt 30 bis 60 $\mu$m, auf und verläuft in x/y-Richtung des Keramik-Metall-Substrats vorzugsweise gerade. Erfindungsgemäß ist daher bevorzugt die Bildung von Bögen oder Radien in der Laserritzlinie nicht vorgesehen. Vorzugsweise werden allenfalls zu Markierungszwecken Konturen durch das Lasern in das Keramik-Metall-Substrat eingebracht.

Die amorphen Phasen 5 können sich nicht nur innerhalb des Keramiksubstrats 2 bilden, sondern auch durch Abplatzungen und Materialspritzer bei der Laserbehandlung auf dem Keramiksubstrat 2 entstehen. Wenn im Rahmen der vorliegenden Erfindung von amorphen Phasen 5 gesprochen wird, so bezieht sich dieser Begriff sowohl auf die amorphe Phase, die innerhalb des Keramiksubstrats 2 durch Einwirkung von thermischer Energie entstehen, als auch auf die amorphe Phase, die auf dem Keramiksubstrat 2 durch Abplatzungen und Materialspritzer gebildet werden.

Im Fall einer Ritzlinie 4, die durch eine gepulste Lasereinwirkung gebildet wird, kann die Ritzlinie 4 durch isolierte Laserkegel gebildet werden.

Im Folgenden wird das im Rahmen der vorliegenden Erfindung vorzugsweise zu verwendende Keramiksubstrat näher beschrieben:

Das Keramiksubstrat enthält vorzugsweise wenigstens eine Verbindung, die aus der Gruppe ausgewählt ist, die aus Metalloxiden und Metallnitriden besteht.

Dabei werden die Metalloxide und Metallnitride vorzugsweise aus der Gruppe ausgewählt, die aus Aluminiumoxid, Aluminiumnitrid und Siliziumnitrid besteht.

Die wenigstens eine Verbindung weist vorzugsweise Korngrößen im Bereich von 0,01 $\mu$m bis 100 $\mu$m auf.

Insbesondere handelt es sich bei der wenigstens einen Verbindung um Aluminiumoxid, wobei das Aluminiumoxid weiter bevorzugt Korngrößen im Bereich von 0,01 $\mu$m bis 25 $\mu$m aufweist.

Des Weiteren weist die wenigstens eine Verbindung vorzugsweise eine Anzahlverteilung der Korngrößen mit einem Medianwert $d_{50}$ und einem arithmetischen Mittelwert $d_{arith}$ auf, wobei das Verhältnis von $d_{50}$ zu $d_{arith}$ vorzugsweise im Bereich von 0,50 bis 1,50, bevorzugt im Bereich von 0,75 bis 1,10, noch bevorzugter im Bereich von 0,78 bis 1,05, besonders bevorzugt im Bereich von 0,80 bis 1,00, liegt.

Besonders bevorzugt ist die wenigstens eine Verbindung Aluminiumoxid und das Aluminiumoxid weist vorzugsweise eine Anzahlverteilung der Korngrößen mit einem Medianwert $d_{50}$ und einem arithmetischen Mittelwert $d_{arith}$ auf, wobei das Verhältnis von $d_{50}$ zu $d_{arith}$ vorzugsweise im Bereich von 0,75 bis 1,10, bevorzugter im Bereich von 0,78 bis 1,05, noch bevorzugter im Bereich von 0,80 bis 1,00 liegt.

Im Rahmen der vorliegenden Erfindung sind diese Werte nicht als strikte Unter- und Obergrenzen für die Korngrößenverteilung anzusehen, sondern können um +/- 10% variieren. In einer bevorzugten Ausführungsform handelt es sich jedoch um die Untergrenze, die nicht unterschritten wird, und Obergrenzen, die nicht überschritten wird.

Wie dem Fachmann grundsätzlich bekannt ist, kann die Bestimmung der Korngrößenverteilung unter Bezugnahme auf die Anzahl der Körner (d.h. Anzahlverteilung) oder alternativ auch unter Bezugnahme auf die Masse (d.h. Massenverteilung) oder das Volumen der Körner erfolgen. Im Rahmen der vorliegenden Erfindung wird die Verteilung der Korngrößen auf Basis der Körneranzahl bestimmt.

Wie allgemein bekannt ist, sind charakteristische Werte einer Korngrößenverteilung unter anderem deren $d_{50}$-Wert, $d_{5}$-Wert und $d_{95}$-Wert. Für den $d_{50}$-Wert, der häufig auch als Medianwert bezeichnet wird, gilt Folgendes: 50% der Körner weisen einen Durchmesser auf, der kleiner ist als der $d_{50}$-Wert.

Der arithmetische Mittelwert $d_{arith}$ einer Korngrößenverteilung ergibt sich aus der Summe der Korngrößen der einzelnen Körner dividiert durch die Körneranzahl.

Die Symmetrie einer Korngrößenverteilung kann über das Verhältnis von Medianwert $d_{50}$ zu dem arithmetischen Mittelwert $d_{arith}$ dieser Verteilung ausgedrückt werden (d.h. durch den Quotienten $d_{50}/d_{arith}$; auch als Symmetriewert einer Korngrößen-Anzahlverteilung bezeichnet). Je näher der Wert dieses Quotienten bei 1,0 liegt, desto symmetrischer ist die Korngrößenverteilung.

Geeignete Methoden, mit denen die Symmetrie der Korngrößenverteilung im Keramiksubstrat, insbesondere Aluminiumoxid, beispielsweise bereits bei der Herstellung des Ausgangssubstrats, eingestellt werden können, sind dem Fachmann bekannt. Beispielsweise kann die Symmetrie der Korngrößenverteilung durch Sinterdauer und Sintertemperatur bei der Herstellung des Ausgangssubstrats beeinflusst werden.

Die Breite und das Volumen der zuvor beschriebenen amorphe Phasen 5, die sich im Wesentlichen parallel zu den jeweils durch Laserablation erzeugten Ausnehmungen oder Kanten der erfindungsgemäßen Keramik-Metall-Substrate erstrecken, werden durch eine geeignete Auswahl an Verfahrensbedingungen der Laserablation generiert.

Diese Verfahrensweise umfasst ein Bearbeiten von einem Keramik-Metall-Substrat 1, bei welchem

a. eine Laserritzlinie als Sollbruchlinie in dem Keramik-Metall-Substrat unter Verwendung eines Laserstrahls erzeugt wird; und/oder

b. ein zumindest teilweises Durchschneiden des Keramik-Metall-Substrats unter Verwendung eines Laserstrahls erfolgt,

wobei die Bearbeitung unter Verwendung eines Lasers erfolgt und bei der Erzeugung der Laserritzlinie als Sollbruchlinie oder bei dem Durchschneiden eine Betriebsgeschwindigkeit (Vortriebsgeschwindigkeit) des Lasers verwendet wird, die so gewählt wird, dass amorphe Phasen des Keramikmaterials nur im beanspruchten Umfang gebildet werden.

Diese im Rahmen der vorliegenden Erfindung beschränkte Menge an amorphen Phasen (wobei eine Beschränkung der Breite der amorphen Phase berücksichtigt wird) zeichnet sich dadurch aus, dass ein Brechen des Keramik-Metall-Substrats 1 aufgrund ausreichender Kerbwirkungen und Spannungserhöhungen möglich ist, gleichzeitig jedoch die Kerbwirkungen und Spannungserhöhungen so reduziert sind, dass die zuvor beschriebenen Nachteile vermieden werden.

Die Bildung von zu großen Mengen an amorphe Phasen des Keramikmaterials in dem Keramik-Metall-Substrat 2 können vermieden werden, wenn der Laser unter bestimmten Verfahrensbedingungen betrieben wird. Hierzu zählen neben der

(a) Bearbeitungsgeschwindigkeit (Vortriebsgeschwindigkeit), insbesondere auch

(a) die Pulsdauer des Lasers;

(b) die Eindringtiefe des Laser in das Keramik-Metall-Substrat; sowie

(c) der Leistung des Lasers.

Im Folgenden werden bevorzugte Ausführungsformen des Lasers beschrieben, mit welchem eine Bildung von amorphen Phasen bei Bearbeitung des Keramik-Metall-Substrats in dem erfindungsgemäß beanspruchten Bereich realisiert werden können.

In dem erfindungsgemäßen Verfahren ist es möglich, dass bei der Erzeugung der Laserritzlinie als Sollbruchlinie die Laserritzlinie in einer Überfahrt oder in mehreren Überfahrten des Lasers erzeugt wird (Ausführungsform Ritzlinie). Auch das Durchschneiden des Keramik-Metall-Substrats kann in mehreren Überfahrten des Lasers erreicht werden (Ausführungsform Durchschneiden).

Im Rahmen der vorliegenden Erfindung kann der Laser ausgewählt sein aus einem n-sec-Laser, p-sec-Laser oder f-sec-Laser, wobei allerdings erfindungsgemäß die Verwendung eines p-sec-Lasers bevorzugt ist.

Ferner ist weiter bevorzugt, wenn der p-sec-Laser eine Pulsdauer, d.h. eine Dauer des Laserpulses, von vorzugsweise 0,1 bis 100 ps, weiter bevorzugt 0,5 bis 50 ps, noch weiter bevorzugt 1 bis 30 ps, aufweist. Mit der gewählten Pulsdauer ist es möglich, den Laserprozess so zu führen, dass nur im erfindungsgemäßen Umfang amorphe Phasen entstehen und somit im Wesentlichen keine Laserspritzer und Laserstäube, die sich auf der Substratoberfläche niederschlagen, gebildet werden. Gleichzeitig wird mit dieser Pulsdauer eine ausreichende Kerbwirkung in der Laserritzlinie erreicht. Da im Rahmen der vorliegenden Erfindung im Wesentlichen nur kalte Stäube und keine amorphen Phasen entstehen und aufgrund eines ausreichend groß gewählten Abstandes von Strahlquelle zu Substratoberfläche ist die Verwendung eines Prozessgases zwar möglich, nicht jedoch zwingend erforderlich.

Die Pulsenergie, d.h. der Energiegehalt eines einzelnen Laserpulses, beträgt vorzugsweise 10 bis 500 $\mu$J, weiter bevorzugt 50 bis 400 $\mu$J, noch weiter bevorzugt 100 bis 350 $\mu$J.

Der p-sec-Laser weist vorzugsweise eine Leistung von 20 bis 400 Watt, weiter bevorzugt 40 bis 200 Watt, noch weiter bevorzugt 50 bis 180 Watt, noch weiter bevorzugt 60 bis 160 Watt, noch weiter bevorzugt 80 bis 130 Watt, noch weiter bevorzugt 90 bis 120 Watt, auf.

Wie bereits vorstehend erwähnt kann insbesondere durch eine geeignete Bearbeitungsgeschwindigkeit die Bildung von amorphen Phasen im erfindungsgemäßen Umfang realisiert werden.

Daher beträgt die Bearbeitungsgeschwindigkeit des Lasers vorzugsweise mindestens 0,75 m/sec, weiter bevorzugt mindestens 0,80 m/sec, weiter bevorzugt mindestens 0,85 m/sec, weiter bevorzugt mindestens 0,90 m/sec, weiter bevorzugt mindestens 0,95 m/sec.

Die Bearbeitungsgeschwindigkeit des Lasers beträgt vorzugsweise höchstens 20,00 m/sec, weiter bevorzugt höchstens 18,00 m/sec, weiter bevorzugt höchstens 17,00 m/sec, weiter bevorzugt höchstens 16,00 m/sec, weiter bevorzugt höchstens 15,00 m/sec.

Die Bearbeitungsgeschwindigkeit des Lasers beträgt vorzugsweise 0,75 bis 20,00 m/sec, weiter bevorzugt 0,80 bis 18,00 m/sec, weiter bevorzugt 0,85 bis 17,00 m/sec, weiter bevorzugt 0,85 bis 16,00 m/sec, weiter bevorzugt 0,90 bis 15,00 m/sec.

Insbesondere sind die in der WO 2005/008849 A2 offenbarten Bearbeitungsgeschwindigkeit des Lasers zu gering, um die Bildung von amorphen Phasen zu vermeiden.

Die Bearbeitungsgeschwindigkeit entspricht dabei der Realgeschwindigkeit, mit welcher sich der Laser über die Keramik bewegt. Entsprechende analoge Ergebnisse lassen sich erzielen, wenn Effektivgeschwindigkeiten des Lasers gewählt werden, bei denen die oben definierten erfindungsgemäßen Realgeschwindigkeiten durch die Anzahl an Überfahrten des Lasers geteilt werden, wobei man von 2 bis 50, vorzugsweise 2 bis 40, weiter bevorzugt 2 bis 30, weiter bevorzugt 2 bis 20, Überfahrten ausgehen kann.

Überraschenderweise hat sich ferner herausgestellt, dass ein Zusammenhang zwischen verwendeter Resonatorleistung (x in Watt) des Lasers und maximaler realer Bearbeitungsgeschwindigkeit (y in m/sec) des Lasers besteht.

Der Zusammenhang folgt allgemein folgender Funktion:

$$y = \sqrt{2{,}3 \bullet x - 40}$$

Hierbei sind die maximalen Bearbeitungsgeschwindigkeiten von der Dicke der Keramik unabhängig.

Sind die realen Bearbeitungsgeschwindigkeiten größer als allgemein oben angegeben oder durch die oben stehende Formel berechnet, ist ein wirkungsvolles und sicheres Brechen der Keramiksubstrate entlang der Laserritzlinie nicht möglich.

In einer weiteren bevorzugten Ausführungsform beträgt die Bearbeitungsgeschwindigkeit des Lasers vorzugsweise mindestens 0,75 m/sec bis zu einer maximalen Bearbeitungsgeschwindigkeit in m/sec, die sich durch die oben genannte Formel

$$y = \sqrt{2{,}3 \bullet x - 40}$$

ergibt, wobei x der Resonatorleistung des Lasers in W entspricht.

In einer weiteren bevorzugten Ausführungsform beträgt die Bearbeitungsgeschwindigkeit des Lasers vorzugsweise mindestens 0,80 m/sec bis zu einer maximalen Bearbeitungsgeschwindigkeit in m/sec, die sich durch die oben genannte Formel

$$y = \sqrt{2{,}3 \bullet x - 40}$$

ergibt, wobei x der Resonatorleistung des Lasers in W entspricht.

In einer weiteren bevorzugten Ausführungsform beträgt die Bearbeitungsgeschwindigkeit des Lasers vorzugsweise mindestens 0,85 m/sec bis zu einer maximalen Bearbeitungsgeschwindigkeit in m/sec, die sich durch die oben genannte Formel

$$y = \sqrt{2{,}3 \bullet x - 40}$$

ergibt, wobei x der Resonatorleistung des Lasers in W entspricht.

In einer weiteren bevorzugten Ausführungsform beträgt die Bearbeitungsgeschwindigkeit des Lasers vorzugsweise mindestens 0,90 m/sec bis zu einer maximalen Bearbeitungsgeschwindigkeit in m/sec, die sich durch die oben genannte Formel

$$y = \sqrt{2{,}3 \bullet x - 40}$$

ergibt, wobei x der Resonatorleistung des Lasers in W entspricht.

Der Spot-Durchmesser des Lasers beträgt vorzugsweise 20 bis 80 $\mu$m, weiter bevorzugt 30 bis 70 $\mu$m, noch weiter bevorzugt 40 bis 60 $\mu$m.

In einer bevorzugten Ausführungsform der vorliegenden Erfindung handelt es sich bei dem verwendeten Laser um einen IR-Laser.

Die zugrundeliegenden Aufgaben der vorliegenden Erfindung werden insbesondere durch die Verwendung eines IR-Lasers, weiter bevorzugt eines p-sec-IR-Lasers, gelöst, wobei, ohne an eine Theorie gebunden zu sein, davon ausgegangen wird, dass das Licht des p-sec-IR-Strahls in die Oberfläche des Keramiksubstrats bzw. in die Oberfläche der Metallbeschichtung besonders wirkungsvoll einkoppelt, d.h. von dem Keramiksubstrat bzw. der Metallbeschichtung besonders wirkungsvoll absorbiert wird. Darüber hinaus weist ein IR-Laser eine hohe Energieeffizienz auf, was zur Lösung der obenstehenden Aufgaben ebenfalls von Vorteil ist.

Ein weiterer Vorteil der Verwendung von einem IR-Laser zur Bearbeitung von Keramiksubstraten bzw. Keramik-Metall-Substraten ist, dass das IR-Laserlicht direkt aus Diodenlicht erzeugt werden kann, wohingegen grünes Laserlicht erst aus IR-Laserlicht mit einem Wirkungsgrad von 60 % hergestellt werden muss und UV-Laserlicht wiederum aus grünem Laserlicht mit einem weiteren Wirkungsgrad von ebenfalls 60 % hergestellt werden muss.

Im Gegensetz zu beispielsweise einem $CO_2$-Laser kann der p-sec-IR-Laser deutlich weiter von dem zu strukturierenden Keramik-Metall-Substrat entfernt angeordnet werden, wodurch sich eine höhere Tiefenschärfe realisieren lässt.

Mithilfe eines IR-Lasers kann darüber hinaus gegenüber einem $CO_2$-Laser eine ausreichend hohe Tiefenschärfe realisiert werden.

Wenn im Rahmen der vorliegenden Erfindung ein IR-Laser verwendet wird, so beträgt die Frequenz des IR-Lasers vorzugsweise 350 bis 650 kHz, weiter bevorzugt 375 bis 625 kHz, noch weiter bevorzugt 400 bis 600 kHz.

Wenn im Rahmen der vorliegenden Erfindung ein IR-Laser verwendet wird, so beträgt die Pulsenergie des IR-Lasers vorzugsweise 100 bis 300 $\mu$J, weiter bevorzugt 125 bis 275 $\mu$J, noch weiter bevorzugt 150 bis 250 $\mu$J.

Das erfindungsgemäße Verfahren gemäß den Alternativen Ritzlinie und Durchschneiden kann in Gegenwart eines Prozessgases durchgeführt werden. Bei dem Prozessgas handelt es sich beispielsweise um Sauerstoff.

Das erfindungsgemäße Verfahren gemäß den Alternativen Ritzlinie und Durchschneiden wird vorzugsweise in einer Vorrichtung durchgeführt, die eine Absaugvorrichtung aufweist, die Stäube absorbiert, welche durch die Laserbearbeitung entstehen.

Im Folgenden werden die Ausführungsformen der Bearbeitung von Keramiksubstraten bzw. Keramik-Metall-Substraten näher beschrieben.

Ausführungsform a.: Laserritzlinie als Sollbruchlinie in dem Keramik-Metall-Substrat

Das Verfahren eignet sich in einer ersten Ausführungsform zur Erzeugung einer Laserritzlinie als Sollbruchlinie in einem Keramik-Metall-Substrat.

Die zu erzeugende Laserritzlinie als Sollbruchlinie in dem Keramik-Metall-Substrat kann entweder durchgängig oder unterbrochen in dem Keramik-Metall-Substrat erzeugt werden. Damit ein anschließendes Brechen des Keramik-Metall-Substrats einfach möglich ist, ist es bevorzugt, wenn die Tiefe der Laserritzlinie 5 bis 50 %, weiter bevorzugt 8 bis 45 %, noch weiter bevorzugt 10 bis 40 %, der Schichtdicke des Keramiksubstrats beträgt.

Bei einem üblichen Keramiksubstrat werden bei der Erzeugung der Laserritzlinie als Sollbruchlinie üblicherweise Parameter des Lasers, d.h. beispielsweise Pulsdauer, Frequenz und Leistung, dergestalt verwendet, dass eine Tiefe der Ritzlinie von mindestens 20 $\mu$m, weiter bevorzugt mindestens 30 $\mu$m, noch weiter bevorzugt mindestens 50 $\mu$m, jeweils bezogen senkrecht auf eine planare Oberfläche des Keramiksubstrats, erzeugt wird.

Durch das erfindungsgemäße Verfahren können Ritzlinien gestaltet werden, die je nach Bedarf hiervon abweichende Tiefen aufweisen. Beispielsweise kann das erfindungsgemäße Verfahren so ausgestaltet sein, dass die Ritztiefe im Anfangsbereich der Ritzlinie höher ist, um eine Initüerung des Bruches zu erleichtern oder um den Bruchverlauf im Übergang zwischen Schneid- und Ritzkonturen zu optimieren. Beispielsweise kann in dem Fall, in welchem die Außenkontur eines Keramik-Metall-Substrats abgerundet werden soll und daher aufgrund des geringen Rundungsradius geschnitten werden muss, sich an den Ecken des Keramik-Metall-Substrats ein Loch ergeben, in dem der Bruchverlauf aus der Ritzlinie gestoppt wird und auf der anderen Seite des Lochs wieder neu initiiert werden muss. In dem Bereich der Neueinleitung des Risses in die Laserritzlinie kann dann vorzugsweise eine höhere Ritztiefe erzeugt werden, um diesen Vorgang der Riss-Neueinleitung zu erleichtern.

Die erfindungsgemäß zu erzeugende Ritzlinie weist eine Breite von vorzugsweise 20 bis 70 $\mu$m, weiter bevorzugt 25 bis 65 $\mu$m, noch weiter bevorzugt 30 bis 60 $\mu$m, auf und verläuft in x/y-Richtung des Keramik-Metall-Substrats vorzugsweise gerade. Erfindungsgemäß ist daher bevorzugt die Bildung von Bögen oder Radien in der Laserritzlinie nicht vorgesehen. Vorzugsweise werden allenfalls zu Markierungszwecken Konturen durch das Lasern in das Keramik-Metall-Substrat eingebracht.

Wie bereits ausgeführt, wird bei der Erzeugung der Laserritzlinie als Sollbruchlinie vorzugsweise eine Betriebsart des Lasers verwendet, die so gewählt wird, dass bei dem Lasern amorphe Phasen des Keramikmaterials im vorstehenden Umfang gebildet werden.

Damit weist die Ritzlinie im Wesentlichen keine Verglasungen an den Seiten der Ritzlinie auf (sogenannter Laseraufwurf). Innerhalb der Ritzlinie selber befinden sich vorzugsweise im Wesentlichen keine, zumindest jedoch kaum Rückstände von Glasphasen (d.h. durch den Laser aufgeschmolzenes, aber nicht entferntes Material). Ferner scheiden sich seitlich der Laserritzlinie im Wesentlichen keine (zumindest kaum) Laserstäube ab.

Die Laserritzlinie weist vorzugsweise Mikrorisse auf, die durch thermische Spannungen während des Laserns entstehen und für das anschließende Brechen der Ritzlinien von Vorteil sind. Darüber hinaus metallisiert die Laserritzlinie in den nachfolgenden galvanischen Verfahrensschritten vorzugsweise nicht.

Im Rahmen der vorliegenden Erfindung ist es möglich, dass die Laserritzlinie durch eine Überfahrt des Lasers über das Keramik-Metall-Substrat erzeugt wird. In einer alternativen Verfahrensweise wird die Laserritzlinie als Sollbruchlinie mit mehreren Überfahrten des Lasers erzeugt, was bevorzugt sein kann, um den spezifischen Energieeintrag, d.h. Energie pro Zeit, gering zu halten. Allerdings ist die Anzahl an Überfahrten vom Material, d.h. der Metallbeschichtung oder der verwendeten Keramik, und von der gewünschten Bearbeitungstiefe abhängig.

Die Bearbeitungsgeschwindigkeit des Lasers hängt von den konkreten Verfahrensbedingungen, d.h. dem verwendeten Laser sowie den verwendeten Materialien für Metallbeschichtung und Keramik sowie der gewünschten Bearbeitungstiefe, ab.

Die Bearbeitungsgeschwindigkeit des Lasers ist vorzugsweise wie vorstehend angegeben.

Ein weiterer Vorteil, der mit der Verwendung eines IR-Lasers einhergeht, ist die Vermeidung von Kreuzungspunkten zweier Ritzlinien. Wenn sich zwei Laserritzlinien kreuzen, besteht bei der Verwendung eines $CO_2$-Lasers die Möglichkeit, dass sich die zwei Laserpulse an derselben Stelle überlagern. Dadurch erhöht sich die Tiefe des Einschussloches. Im Extremfall kann es zu einem Durchschuss kommen, der bis auf die gegenüberliegende Keramik-Seite reicht. Das kann sich negativ auf das Brechverhalten oder auch auf die spätere mechanische Festigkeit des Substrats auswirken. Aufgrund der sehr hohen Präzision der IR-Lasertechnologie, insbesondere bei der Verwendung eines p-sec-IR-Lasers, sowie der Tatsache, dass alle Ritzlinien mehrfach abgefahren werden und sich somit keine Bevorzugung einer Ritzlinie ergibt, kann einfach eine der Ritzlinien unterbrochen werden oder die Parameter im Kreuzungsbereich werden angepasst und somit eine erhöhte Ritztiefe im Kreuzungsbereich vermieden.

Ein weiterer Vorteil gegenüber der Verwendung von $CO_2$-Lasern ergibt sich beim Vorlasern von Keramiken mit dem erfindungsgemäß vorgesehenen IR-Laser, insbesondere p-sec-IR-Laser. Im Bereich der Keramik-Metall-Substrate gibt es Produkte, bei denen vorgelaserte Keramiken verwendet werden. Hierbei wird die Keramik bereits vor dem Verbindungsprozess von Metall und Keramik gelasert. Beispiele hierfür sind Produkte mit Durchkontaktierung (Vias) oder überstehendem Metall (Lead-off). Im Fall der Bearbeitung mit $CO_2$-Lasern müssen die während des Laserns entstehenden Stäube und Laseraufwurf wieder entfernt werden. Dieses erfolgt beispielsweise mit Tellerbürsten, Ultraschall-Reinigungsanlagen, Läppen oder anderen mechanischen Verfahren. Chemische Verfahren sind im Fall von Aluminiumoxid aufgrund seiner hohen chemischen Beständigkeit nicht sinnvoll einsetzbar. Durch den Einsatz entsprechender IR-Laser entstehen keine Stäube und Aufwurf, die entfernt werden müssen. Eine entsprechende Aufreinigung kann daher vermieden werden.

Ausführungsform b.: Durchschneiden des Keramik-Metall-Substrats unter Verwendung eines Laserstrahls

Teilweise besteht Bedarf, Konturen in die Keramik-Metall-Substrate einzubringen, die von einer geraden Linie abweichen. Hierbei kann es sich beispielsweise um Löcher in der Mitte eines Keramik-Metall-Substrats oder um Abrundungen an den Ecken des Keramik-Metall-Substrats handeln. Solche Konturen können erhalten werden, in dem die Keramik des Keramik-Metall-Substrats unter Anwendung des Lasers durchschnitten wird.

Wenn im Rahmen der vorliegenden Erfindung das Keramiksubstrat mittels eines Lasers durchschnitten wird, liegt kein Einstichpunkt vor, bei dem ein initiales Durchtrennen der Keramik stattgefunden hat. Daher ist es im Rahmen der vorliegenden Erfindung auch nicht notwendig, außerhalb der Kontur einzustechen und mit einer Anfahrtrampe sich der eigentlichen Schneidkontur anzunähern.

Wenn im Rahmen der vorliegenden Erfindung das Keramiksubstrat unter Anwendung des Lasers durchtrennt wird, weisen die Schneidflanken einen Winkel auf, der üblicherweise um vorzugsweise maximal 30 °, weiter bevorzugt maximal 25 °, von einem rechten Winkel abweicht. Daraus ergibt sich ein Loch, dass auf der Oberseite größer als auf der Unterseite ist.

Ein weiterer Vorteil der erfindungsgemäßen Durchtrennung des Keramiksubstrats mit einem IR-Laser, insbesondere p-sec-IR-Laser, ist, dass an der Unterseite, d.h. der Laseraustrittseite, keine durch amorphe Phasen gebildeten Grate entstehen, die in einem zusätzlichen Verfahrensschritt entfernt werden müssten.

Vorteile der Ausführungsformen a. und b.

Unter Berücksichtigung der oben beschriebenen Ausführungsformen a. und b. ist es möglich, die Metallbeschichtung und das Keramik-Substrat mit demselben Laser zu bearbeiten. Hierdurch lässt sich kostengünstig eine Fertigung von Keramik-Metall-Substraten mit strukturierter Metallbeschichtung realisieren. Im Detail ist es möglich,

    I) nur die obere Metallbeschichtung teilweise abzutragen oder bis zur Keramik zu durchtrennen und beispielsweise feine Strukturen in der Metallbeschichtung zu erzeugen, die mit einem Ätzvorgang nicht möglich sind;

II) die Metallbeschichtung und das Keramik-Substrat bis zur unteren Metallbeschichtung zu durchtrennen (damit kann die Grundlage für Durchkontaktierung geschaffen werden. Füllt man entsprechende Sacklöcher mit einem leitfähigen Material, ist eine Durchkontaktierung hergestellt. Als Füllmaterial eignen sich beispielsweise metallische Pasten oder galvanisch erzeugte Materialien.);

III) Metallbeschichtung und Keramik-Substrat zu durchtrennen bzw. nur die Metallbeschichtung oder das Keramik-Substrat zu durchtrennen, sofern auf der Oberseite des Keramik-Substrats keine Metallbeschichtung vorliegt (beispielsweise weil es bereits weggeätzt oder gar nicht erst aufgebracht wurde).

Das Verfahren der Bearbeitung eines Keramik-Metall-Substrates gemäß den Ausführungsformen a. und b. wird vorzugsweise in Gegenwart eines Prozessgases durchgeführt, wobei als Prozessgas beispielsweise Sauerstoff oder Druckluft verwendet werden kann. Wie bereits oben ausgeführt, ist die Verwendung eines Prozessgases nicht zwingend erforderlich, kann jedoch angeraten sein, um die Strahlquelle vor Verunreinigungen zu schützen. In diesem Fall würde sich die Verwendung von Druckluft als bevorzugte Alternative anbieten.

Da in dem Verfahren durch die Laserbearbeitung Stäube entstehen, ist es besonders bevorzugt, wenn die verwendete Vorrichtung eine Absaugvorrichtung aufweist, die Stäube absorbiert, welche durch die Laserbearbeitungen entstehen.

Die Absaugvorrichtung kann beispielsweise durch ein absaugendes Rohr oder einen absaugenden Kasten gebildet werden, der das projizierte Laserlicht umhüllt und dessen Unterkante einen Abstand zur Oberfläche des Keramik-Metall-Substrats von vorzugsweise 0,5 bis 10 cm, weiter bevorzugt von 0,75 bis 7,5 cm, noch weiter bevorzugt 1 bis 5 cm, aufweist.

Bei einem Keramiksubstrat mit einer Schichtdicke von 0,63 mm beträgt die Zieltiefe der Laserritzlinie vorzugsweise 40 bis 140 $\mu$m, weiter bevorzugt 50 bis 130 $\mu$m, noch weiter bevorzugt 60 bis 120 $\mu$m.

Darüber hinaus weist das Keramik-Metall-Substrat eine Breite des Ritzgrabens von vorzugsweise 15 bis 75 $\mu$m, weiter bevorzugt 20 bis 70 $\mu$m, noch weiter bevorzugt 25 bis 65 $\mu$m, auf.

Das mit dem Verfahren bearbeitete Keramiksubstrat ist im Wesentlichen frei von Verglasungen an den Seiten der Ritzlinie und innerhalb der Ritzlinie im Wesentlichen frei von Rückständen von Glasphasen. Aufgrund der im Bereich der Ritzlinie gebildeten Mikrorisse ist ein Brechen des Keramiksubstrats ohne Schwierigkeiten möglich.

Das erfindungsgemäße Keramik-Metall-Substrat kann eine durch die Behandlung mit dem IR-Laser erhaltene Kontur aufweisen, die von einer geraden Linie abweicht und die mittels Durchschneiden des Keramiksubstrats unter Verwendung eines Laserstrahls erzeugt wurde. Darüber hinaus ist es möglich, dass das erfindungsgemäße Keramik-Metall-Substrat Löcher und/oder Abrundungen an den Ecken aufweist, welche mittels des Durchschneidens des Keramiksubstrats erzeugt wurden.

Das durch das IR-Laser-Verfahren mit einem p-sec-IR-Laser erhaltene Keramik-Metall-Substrat weist Schneidflanken mit einem Winkel auf, der um vorzugsweise maximal 30 °, weiter bevorzugt maximal 25 °, von einem rechten Winkel abweicht. Sollten durch das IR-Laser-Verfahren Löcher in das Keramik-Metall-Substrat eingebracht werden, so kann deren Größe auf den beiden Seiten des Keramiksubstrats unterschiedlich sein. Allerdings weist das Keramik-Metall-Substrat vorzugsweise an dem Loch und/oder Abrundung keinen Grat auf.

Durch das IR-Laser-Verfahren sind Keramik-Metall-Substrate erhältlich, die eine Kodierung auf der Metallbeschichtung des Keramik-Substrats aufweisen. Diese Kodierung wird vorzugsweise durch ein Abtragen der Metallbeschichtung durch den IR-Laser bewirkt.

Mit dem Verfahren sind darüber hinaus Keramik-Metall-Substrate erhältlich, bei welchen die Metallisierung auf dem Keramiksubstrat mindestens eine Randabschwächung aufweist oder aber in welchen die Metallisierung mindestens eine Vertiefung zur Aufnahme von elektronischen Bauteilen, insbesondere Chips, aufweist, wobei die Vertiefung durch eine Laserbehandlung erzeugt wurde.

Bezugszeichenliste:

1    Keramik-Metall-Substrat

2    Keramiksubstrat

3    Metallisierung

4    Ritzlinie

5    amorphe Phase

6    Kante der Ritzlinie 4

7    Mittellinie der Ritzlinie 4

8    Schneidkante des Keramiksubstrats 2

9    Ätzflanke der Metallisierung 3

10    Ausnehmung in der Metallisierung 3

11    innenliegende Kante der Schneidkante 8

12 außenliegende Kante der Schneidkante 8

**Patentansprüche**

**1.** Keramik-Metall-Substrat (1), umfassend ein Keramiksubstrat (2) und auf mindestens einer Seite des Keramiksubstrats eine Metallisierung (3), **dadurch gekennzeichnet, dass** das Keramiksubstrat (2) mindestens eine Ritzlinie (4) und/oder Schneidkante (8) aufweist, wobei sich amorphe Phasen (5) parallel zu der Ritzlinie (4) und/oder der Schneidkante (8) in einem Bereich einer Breite a von höchstens 100 µm erstrecken.

**2.** Keramik-Metall-Substrat (1), umfassend ein Keramiksubstrat (2) und auf mindestens einer Seite des Keramiksubstrats eine Metallisierung (3), **dadurch gekennzeichnet, dass** das Keramiksubstrat (2) mindestens eine Ritzlinie (4) und/oder Schneidkante (8) aufweist, wobei sich amorphe Phasen (5) parallel zu der Ritzlinie (4) und/oder der Schneidkante (8) in einem Bereich einer Breite a von mindestens 0,50 µm erstrecken.

**3.** Keramik-Metall-Substrat (1) nach Patentanspruch 1 oder 2, **dadurch gekennzeichnet, dass** das Keramiksubstrat (2) mindestens eine Ritzlinie (4) aufweist und die amorphen Phasen (5) sich, ausgehend von der Ritzlinie (4) und parallel zur Ritzlinie (4) verlaufend, in einem Bereich einer Breite a, berechnet von der Kante 6 der Ritzlinie 4, von höchstens 50 µm erstrecken.

**4.** Keramik-Metall-Substrat (1) nach einem der Patentansprüche 1 bis 3, **dadurch gekennzeichnet, dass** das Keramiksubstrat (2) mindestens eine Ritzlinie (4) aufweist und die amorphe Phasen (5) sich, ausgehend von der Ritzlinie (4) und parallel zur Ritzlinie (4) verlaufend, in einem Bereich einer Breite a, berechnet von der Kante der Ritzlinie (4), von mindestens 0,50 µm erstrecken.

**5.** Keramik-Metall-Substrat (1) nach Patentanspruch 1 oder 2, **dadurch gekennzeichnet, dass** das Keramiksubstrat (2) mindestens eine Ritzlinie (4) aufweist und die amorphe Phasen (5) sich, ausgehend von der Ritzlinie (4) und parallel zur Ritzlinie (4) verlaufend, in einem Bereich einer Breite a, berechnet von der Mittellinie (7) der Ritzlinie (4), von höchstens 100 µm erstrecken.

**6.** Keramik-Metall-Substrat (1) nach einem der Patentansprüche 1, 2 oder 5, **dadurch gekennzeichnet, dass** das Keramiksubstrat (2) mindestens eine Ritzlinie (4) aufweist und die amorphe Phasen (5) sich, ausgehend von der Ritzlinie (4) und parallel zur Ritzlinie (4) verlaufend, in einem Bereich einer Breite a, berechnet von der Mittellinie (7) der Ritzlinie (4), von mindestens 0,50 µm erstrecken.

**7.** Keramik-Metall-Substrat (1) nach Patentanspruch 1 oder 2, **dadurch gekennzeichnet, dass** das Keramiksubstrat (2) mindestens eine Schneidkante (8) aufweist und die amorphe Phasen (5) sich, ausgehend von der oberen Kante (11) der Schneidkante (8) und parallel zur Schneidkante (8) verlaufend, in einem Bereich einer Breite a, berechnet von der oberen Kante (11) der Schneidkante (8), von höchstens 50 µm erstrecken.

**8.** Keramik-Metall-Substrat (1) nach einem der Patentansprüche 1, 3 oder 7, **dadurch gekennzeichnet, dass** das Keramiksubstrat (2) mindestens eine Schneidkante (8) aufweist und die amorphe Phasen (5) sich, ausgehend von der oberen Kante (11) der Schneidkante (8) und parallel zur Schneidkante (8) verlaufend, in einem Bereich einer Breite a, berechnet von der oberen Kante (11) der Schneidkante (8), von mindestens 0,50 µm erstrecken.

**9.** Keramik-Metall-Substrat (1) nach Patentanspruch 1 oder 2, **dadurch gekennzeichnet, dass** das Keramiksubstrat (2) mindestens eine Schneidkante (8) aufweist und die amorphe Phasen (5) sich, ausgehend von der unteren Kante (12) der Schneidkante (8) und parallel zur Schneidkante (8) verlaufend, in einem Bereich einer Breite a, berechnet von der unteren Kante (12) der Schneidkante (8), von höchstens 100 µm erstrecken.

**10.** Keramik-Metall-Substrat (1) nach einem der Patentansprüche 1, 3 oder 7, **dadurch gekennzeichnet, dass** das Keramiksubstrat (2) mindestens eine Schneidkante (8) aufweist und die amorphe Phasen (5) sich, ausgehend von der unteren Kante (12) der Schneidkante (8) und parallel zur Schneidkante (8) verlaufend, in einem Bereich einer Breite a, berechnet von der unteren Kante (12) der Schneidkante (8), von mindestens 0,50 µm erstrecken.

**11.** Keramik-Metall-Substrat (1) nach einem der Patentansprüche 1 bis 10, **dadurch gekennzeichnet, dass** die Ritzlinie (4) und/oder Schneidkante (8) durch Laserablation erhalten wird.

**12.** Keramik-Metall-Substrat (1) nach einem der Patentansprüche 1 bis 11, **dadurch gekennzeichnet, dass** die Bildung der amorphe Phasen (5) gesteuert wird durch die Geschwindigkeit und/oder Leistung des Lasers während der Laserablation.

**13.** Verwendung eines Keramik-Metall-Substrats (1) gemäß einem der Patentansprüche 1 bis 12 als Schaltungsträger für Leistungselektronik-Anwendungen.

Figur 1:

Figur 2:

Figur 3:

Figur 4:

Figur 5:

Figur 6:

Figur 7:

Europäisches
Patentamt

European
Patent Office

Office européen
des brevets

## EUROPÄISCHER RECHERCHENBERICHT

Nummer der Anmeldung

EP 17 17 7320

### EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | EP 2 579 693 A1 (KYOCERA CORP [JP]) 10. April 2013 (2013-04-10) * Absätze [0001], [0002], [0004], [0030], [0031], [0086]; Ansprüche 1-12; Abbildungen 2, 3, 5, 6, 8; Tabellen 1, 2 *  ----- | 1-13 | INV. C04B37/02 H01L21/02 H01L21/48 H05K3/00 B23K26/364 |
| X | JP 2008 041945 A (MITSUBISHI MATERIALS CORP) 21. Februar 2008 (2008-02-21) * Absatz [0001]; Ansprüche 1-3; Abbildungen 1, 2 *  ----- | 1-13 | |
| A | WO 2005/096323 A1 (MITSUBISHI MATERIALS CORP [JP]; KAMAYA ELECTRIC CO LTD [JP]; TOHYAMA H) 13. Oktober 2005 (2005-10-13) * Ansprüche 1-8; Abbildungen 1-9 *  ----- | 1-13 | |

RECHERCHIERTE SACHGEBIETE (IPC)

C04B
H01L
H05K
B23K

Der vorliegende Recherchenbericht wurde für alle Patentansprüche erstellt

| Recherchenort | Abschlußdatum der Recherche | Prüfer |
|---|---|---|
| Den Haag | 15. Dezember 2017 | Süzük, Kerem Güney |

EPO FORM 1503 03.82 (P04C03)

**ANHANG ZUM EUROPÄISCHEN RECHERCHENBERICHT**
**ÜBER DIE EUROPÄISCHE PATENTANMELDUNG NR.**

EP 17 17 7320

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

15-12-2017

| Im Recherchenbericht angeführtes Patentdokument | Datum der Veröffentlichung | Mitglied(er) der Patentfamilie | Datum der Veröffentlichung |
|---|---|---|---|
| EP 2579693 A1 | 10-04-2013 | CN 102687599 A<br>EP 2579693 A1<br>JP 2012009767 A<br>US 2013078408 A1<br>WO 2011149097 A1 | 19-09-2012<br>10-04-2013<br>12-01-2012<br>28-03-2013<br>01-12-2011 |
| JP 2008041945 A | 21-02-2008 | KEINE | |
| WO 2005096323 A1 | 13-10-2005 | CN 1977347 A<br>HK 1105713 A1<br>JP 2005317927 A<br>KR 20070024506 A<br>TW 200537532 A<br>WO 2005096323 A1 | 06-06-2007<br>18-02-2011<br>10-11-2005<br>02-03-2007<br>16-11-2005<br>13-10-2005 |

EPO FORM P0461

Für nähere Einzelheiten zu diesem Anhang : siehe Amtsblatt des Europäischen Patentamts, Nr.12/82

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- WO 2005008849 A2
- US 9165832 B
- EP 2016082161 W